# EUROPEAN PATENT APPLICATION

(11) **EP 1 804 124 A1**
(43) Date of publication of application: **04.07.2007**
(21) Application number: 05780871.9
(22) Date of filing: 29.08.2005
(51) Int. Cl.: G03F 7/32, H01L 21/027

(54) **DEVELOPING SOLUTION COMPOSITION FOR LITHOGRAPHY AND METHOD FOR RESIST PATTERN FORMATION**

(30) Priority: 01.09.2004 JP 2004254938
(71) Applicant: TOKYO OHKA KOGYO CO., LTD., Kawasaki-shi, Kanagawa 211-0012 (JP)
(72) Inventor: KOSHIYAMA, Jun, TOKYO OHKA KOGYO CO., LTD.,, Kawasaki-shi, Kanagawa 2110012 (JP); WAKIYA, Kazumasa, TOKYO OHKA KOGYO CO., LTD.,, Kawasaki-shi, Kanagawa 2110012 (JP); SAWADA, Yoshihiro, TOKYO OHKA KOGYO CO., LTD., Kawasaki-shi, Kanagawa21 10012 (JP)
(74) Representative: Hayes, Adrian Chetwynd
(86) International application number: PCT/JP2005/015611
(87) International publication number: WO 2006/025292

(57) **Abstract**

This invention provides a novel developing solution composition for lithography, which can efficiently reduce defects without varying the formulation of a resist composition per se and without sacrificing the quality of a resist pattern by the use thereof, and a novel method for resist pattern formation using the developing solution composition, which can reduce the occurrence of defects and can be combined with subsequent specific rinsing liquid treatment to control pattern collapse. The developing solution composition comprises a solution containing tetraalkylammonium hydroxide and at least one polymer selected from water soluble or alkali soluble polymers comprising monomer constituent units with a nitrogen-containing heterocyclic ring. A resist pattern is formed by the following steps: (1) the step of providing a resist film on a substrate; (2) the step of selectively exposing the resist film thorough a mask pattern; (3) the step of heating the film after exposure; and (4) the step of developing the film with the above composition.

## Description

### TECHNICAL FIELD

The present invention relates to a developer composition for lithography capable of decreasing the defects generated on products as well as to a resist pattern-forming method by using the same.

### BACKGROUND TECHNOLOGY

Along with the trend in recent years toward compactness and high integration of semiconductor devices, the light sources for the fine working thereof are also under a trend of shift to shorter wavelength ones from traditional UV light to the g-line (436 nm) capable of forming a resist pattern of higher pattern resolution, from the g-line to the i-line (365 nm) and from the i-line to the KrF excimer laser (248 nm) to accomplish shorter and shorter wavelengths leading to the current ArF excimer laser (193 nm), F₂ excimer laser (157 nm) and further electron beams such as EB and EUV shifter as a major current while developments of the process and resist materials are under progress at a high pace in order to comply with these short-wavelength light sources.

Conventional photoresists are required to have: for instance, improved sensitivity, pattern resolution, heat resistance, focusing depth latitude, cross sectional profile of a resist pattern and aging stability resulting in the deterioration of the shape of the resist pattern due to contamination with amine and the like in a period between light exposure and post-exposure baking (PEB) and controlled substrate dependency which changes are caused in the cross sectional profile of the resist pattern depending on various coating films provided on the silicon wafer such as insulating films including silicon nitride (SiN) films, semiconductor films including polycrystalline silicon (poly-Si) films and metallic films including titanium nitride (TiN) films. These requirements have been solved to some extent, but a defect which is a particularly important issue has many problems remaining unsolved.

The defect means a mismatch between a resist pattern and a photomask pattern, which is detected when a resist pattern after having been developed is examined from right above with a surface defect observation instrument, for instance, the mismatch like a difference between shapes of the patterns, occurrence of scums and contaminants, irregular coloring and coalescence between the patterns and the like. The yield of the semiconductor devices decreases as the number of defects increases so that, even though the photoresist has the adequate resist characteristics as described above, defects make it difficult for the semiconductor devices to be effectively mass produced, while the problems thereof remain unsolved. Accordingly, many attempts have been heretofore made for the means to decrease such defects.

For example, proposals are made for the solvents used in the preparation of a coating solution for chemical-amplification positive-working resists including a mixed solvent of a propyleneglycol monoalkylacetate and a hydroxyl-based organic solvent having a boiling point of 80-200 °C used in a defects-reducing coating solution (JP2000-267269A), a method, in the formation of a resist pattern by using a chemical-amplification positive-working resist, in which formation of a resist film is followed by coating of a defects-preventing agent containing a hydrophobic group and a hydrophilic group on the resist film prior to the post-exposure baking treatment (JP2001-23893A), a method for resist pattern formation by using a chemical-amplification positive-working resist in which the resist film after the post-exposure baking treatment is subjected to an acid treatment (JP 2001-215734A), a method, in manufacturing semiconductor devices by using a chemical-amplification positive-working resist composition, in which adjustment is made for bringing the alkali-dissolving velocity of the aforementioned resist composition before light-exposure to a specified value (JP2002-148816A), an aqueous solution of a treatment agent for defects decreasing in a chemical-amplification resist pattern having a pH of 3.5 or lower and containing a hardly vaporizable aromatic sulfonic acid having a molecular weight of at least 200 (JP2002-323774A) and so on.

Even though these methods or compositions are suitable for decreasing the defects, however, it would be the case that the resist patterns obtained thereby are subject to a decrease in the quality thereof or alteration of the formulated composition of the resist compositions to cause a problem that the process per se must be modified whereby the existing facilities can no longer be utilized. Therefore, they are not always satisfactory.

### DISCLOSURE OF THE INVENTION

The present invention has been completed with an object to provide a novel developer composition for lithography capable of efficiently decreasing the defects without being accompanied by a decrease in the quality of the resist pattern obtained by using the same without modification of the formulation of the resist composition *per se* as well as a novel method for the resist pattern formation in which occurrence of defects can be decreased by utilizing the developer solution and further pattern falling can be controlled by a combination with a subsequent treatment with a specified rinse solution.

The inventors have continued extensive investigations for suppressing the decrease in the productivity of semiconductor products due to the defects in the resist patterns accompanying the manufacture of various kinds of semiconductor devices by utilizing the technology of lithography arriving, as a result thereof, at a discovery that, in the development treatment undertaken after image formation of the photoresist film, by the admixture of a specified water-soluble or alkali-soluble polymer with the heretofore employed alkaline developer solution, the contact angle on the surface of the photoresist film treated with the alkaline developer solution to the developer solution is decreased to facilitate contacting with the developer solution so that the development can proceed smoothly and, in addition, the defects due to the occurrence of microbubbles can be decreased and that, by further undertaking a rinse treatment after the development treatment with a rinse solution containing a specified fluorine-containing modifying agent, the contact angle is increased to prevent the pattern falling which occurs in the course of fine photomask pattern formation leading to completion of the present invention on the base thereof.

Thus, the present invention provides a developer composition for lithography comprising a solution containing:
(A) a tetraalkylammonium hydroxide;
(B) a water-soluble or alkali-soluble polymer having, in the molecular structure, constituent monomeric units having a nitrogen atom;
   and, optionally
(C) at least one kind selected from aliphatic alcohols and alkyl etherified compounds thereof;
   as well as a resist pattern-forming method comprising:
   (1) a step of providing a resist film on a substrate;
   (2) a step of selective light exposure of the said resist film through a photomask pattern;
   (3) a step of subjecting the aforementioned resist film after the light-exposure treatment to a post-exposure baking treatment (referred to hereinbelow as PEB treatment);
   (4) a step of subjecting the aforementioned resist film after the PEB treatment to a development treatment with the aforementioned developer solution for lithography; and optionally
   (5) a step of subjecting the aforementioned resist film after the development treatment to a rinse treatment with an aqueous solution of an alcoholic solution containing a fluorine-containing modifying agent.

In the following, the present invention is described in detail.

The component (A) in the inventive developer composition for lithography is an organic base component conventionally used in the formation of resist patterns by using a chemical-amplification photoresist or, namely, a tetraalkylammonium hydroxide. The alkyl group existing in this compound is, preferably, in respect of the exhibition of strong basicity, a lower alkyl group such as, for example, methyl group, ethyl group, propyl group and the like, of which methyl group is particularly preferable.

Examples of such a tetraalkylammonium hydroxide include tetramethylammonium hydroxide, trimethylethylammonium hydroxide, trimethylpropylammonium hydroxide, dimethyldiethylammonium hydroxide, triethylmethylammonium hydroxide, tetraethylammonium hydroxide, (2-hydroxyethyl)trimethylammonium hydroxide and the like, of which tetramethylammonium hydroxide is particularly preferable.

In the next place, the component (B) used in the inventive developer composition for lithography is a water-soluble or alkali-soluble polymer having constituent monomeric units containing a nitrogen atom in the molecular structure. The nitrogen atom can be contained in the functional molecular chain of a polymer or can be contained in the side chain as a nitrogen-containing substituent.

The polymer containing a nitrogen atom in the functional molecular chain is exemplified, for example, by a polymer of lower alkyleneimines or a copolymer of a lower alkyleneimine and another monomer capable of forming a water-soluble polymer by itself, of which polyethyleneimine is particularly preferred in respect of easy availability thereof.

The polyethyleneimine can be easily produced, for example, by polymerization of ethyleneimine in the presence of an acidic catalyst such as carbon dioxide, chlorine, hydrogen bromide, *p*-toluenesulfonic acid and the like and it is available as a commercial product.

The polymer containing nitrogen-containing substituent groups on the side chains is exemplified by the polymers or copolymers of an unsaturated hydrocarbon having an amino group or a substituted amino group or a nitrogen-containing heterocyclic group. The polymer of an unsubstituted hydrocarbon having an amino group is exemplified, for example, by polyallylamines. The polyallylamine can readily be obtained, for example, by heating allylamine hydrochloride in the presence of a radical polymerization initiator.

The polymer containing a nitrogen-containing substituent used in the present invention is preferably a water-soluble or alkali-soluble polymer having monomeric units containing a nitrogen-containing heterocyclic group represented by the general formula, 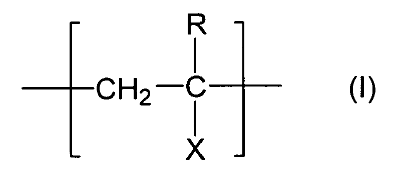 (R in the formula is a hydrogen atom or a methyl group and X is a nitrogen-containing heterocyclic group).

Examples of the nitrogen-containing heterocyclic group denoted by X in the above given general formula (I) include, for example, a pyrrolyl group, imidazolyl group, pyrazolyl group, thiazolyl group, oxazolyl group, isoxazolyl group, pyridyl group, pyrazyl group, pyrimidyl group, pyridazyl group, triazolyl group, indolyl group, quinolyl group, butyrolactam group, caprolactam group and the like and also include other nitrogen-containing heterocyclic groups.

The bonding position of these heterocyclic groups to the base carbon chain is not particularly limitative and can be at a nitrogen atom or can be at a carbon atom.

The polymer containing a nitrogen-containing heterocyclic group used in the present invention can be a copolymer of: a monomeric unit having a nitrogen-containing heterocyclic group expressed by the above given general formula (I); and a monomeric unit derived from a monomer capable of singly forming a water-soluble polymer.

The component (B) can be obtained, for example, by polymerizing a monomer having a nitrogen-containing heterocyclic group expressed by the general formula 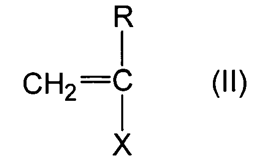 (R and X in the formula have the same meanings as before)
or a mixture of the monomer having a nitrogen-containing heterocyclic group expressed by the above given general formula (II) and a monomer capable of singly polymerizing to form a water-soluble polymer. The polymerization in this case means homopolymerization or copolymerization.

Particularly preferable ones among the monomers having nitrogen-containing heterocyclic rings expressed by the above given general formula (II) include vinyl imidazole, vinyl imidazoline, vinyl pyridine, vinyl pyrrolidone, vinyl morpholine and vinyl caprolactam, of which vinyl imidazole and vinyl pyrrolidone are the most preferable.

The monomers capable of forming a water-soluble polymer, when polymerized singly, which can be used in combination with the aforementioned monomers having a nitrogen-containing heterocyclic ring, include, for example, vinyl acetate (forming a vinyl alcohol unit by hydrolysis) and monomers containing no nitrogen atoms such as hydroxyalkyl esters of acrylic acid or methacrylic acid and the like. It is optional that they are copolymerized singly with a monomer having a nitrogen-containing heterocyclic group or copolymerized as a mixture of two kinds or more with a monomer having a nitrogen-containing heterocyclic group.

The polymerization or copolymerization of a monomer having a nitrogen-containing heterocyclic ring or a mixture of the monomer and a monomer capable of singly polymerizing to form a water-soluble polymer can be performed according to known methods such as the solution polymerization method and suspension polymerization method.

The proportion in this case between the monomer having a nitrogen-containing heterocyclic group and the monomer capable of forming a water-soluble polymer by its single polymerization is selected in the range of 10:0 to 1:9 or, preferably, 9:1 to 2:8 by mass. When the proportion of the monomer having a nitrogen-containing heterocyclic group is smaller than above, the adsorbing performance onto the resist surface is decreased so that the desired characteristic or, namely, pattern-falling preventing power is decreased. The mass-average molecular weight of this comonomer is selected in the range of 500 to 1500000 or, preferably, 1000 to 50000.

Such a comonomer is known and marketed from, for example, BASF Corp. [product name LUVITEC VPI55 K72W and Sokalan HP56] and polyvinylimidazoline is marketed from TOSOH CORP.

The aliphatic alcohol or an alkyl-etherified compound thereof used as the component (C) acts to defoam the microbubbles generated in coating with the rinse solution and, even in coating of a large-size wafer, acts to form a uniform coating film by causing dispersion or diffusion of the component (A), i.e. the water-soluble or alkali-soluble polymer, in the developer solution onto the surface.

The aliphatic alcohol or an alkyl-etherified compound thereof may have a single hydroxyl group or may have two or more thereof. Such a compound is exemplified by alkanols and alkyl ethers thereof such as, for example, methanol, ethanol, 1-propanol, 2-propanol, n-butyl alcohol, isobutyl alcohol, *tert*-butyl alcohol, diethyl ether and ethyl propyl ether and those by substitution of fluorine atoms for a part or all of the hydrogen atoms therein such as trifluoroethanol, dichloroethanol and the like, alkylene glycols and alkyl-etherified compounds thereof such as, for example, 1,2-ethyleneglycol, 1,3-propanediol, 1,4-butanediol, 2,3-butanediol and 1,5-pentanediol and their methyl ethers, ethyl ethers, propyl ethers and the like, polyalkyleneglycols or their alkyl-etherified compounds such as, for example, diethyleneglycol, triethyleneglycol, tetraethyleneglycol, polyethyleneglycols having a molecular weight of 100 to 10000, dipropyleneglycol, tripropyleneglycol, polypropyleneglycols having a molecular weight of 100 to 10000, poly(oxyethylene/oxypropylene) glycols having a molecular weight of 100 to 10000 and methyl ethers, ethyl ethers, propyl ethers thereof and the like, glycerin and others.

They can be used alone or can be used as a combination of two kinds or more.

In the inventive developer composition for lithography, which is prepared in such a way that the concentration of the component (A) is in the range of 0.5 to 10.0% or, preferably, 1.0 to 5.0% by mass, the concentration of the component (B) is in the range of 0.001 to 10% or, preferably, 0.01 to 3% by mass and the concentration of the component (C) is in the range of 0.0001 to 15% or, preferably, 0.005 to 10% by mass, higher concentrations can be used according to need. When the component (C) used is a polyalkyleneglycol, a sufficient effect can be noted even in a concentration of 0.05% by mass or lower.

It is optional according to desire that the inventive developer composition for lithography is admixed with an anionic surfactant or a nonionic surfactant with an object of improvement of the coating behavior thereof. The aforementioned anionic surfactant includes, for example, N-higher alkyl pyrrolidones, higher alkylbenzyl quaternary ammonium salts and the like and the nonionic surfactant includes higher fatty acid polyethylene oxide condensates and the like, of which particularly preferable are N-octyl-2-pyrrolidone, N-laurylpiperidine and the like. These surfactants are used in a proportion of 0.001 to 0.5% by mass or, preferably, 0.005 to 0.1 % by mass based on the total amount of the developer composition.

In the next place, the resist pattern forming method of the present invention comprises the first step of providing a resist film on a substrate, the second step of a light-exposure treatment of the said resist film through a photomask pattern for the selective formation of a latent image, the third step of a PEB treatment of the said resist film after the light-exposure treatment, the fourth step of a development treatment of the said resist film after the PEB treatment with the aforementioned inventive developer composition for lithography and, optionally, the fifth step of a rinse treatment of the said resist film after the development treatment with an aqueous solution or an alcoholic solution containing a fluorine-containing modifying agent.

The first step is a step in which a resist film is formed on a substrate.

The substrate usually has a wiring layer consisting of a variety of metals and alloys including aluminum, copper, titanium-tungsten alloys, aluminum-silicon alloys, aluminum-copper-silicon alloys and the like, an insulating layer consisting of a ceramic such as silicon oxide, silicon nitride, titanium nitride and the like, a low dielectric layer consisting of an organic or inorganic material and further an antireflection layer consisting of an organic or inorganic material.

In order to form a resist film on this substrate, for example, coating is performed on a spinner and the like with a solution of a chemical-amplification resist composition conventionally used in the manufacture of semiconductor devices.

This chemical-amplification resist composition essentially consists of a resinous component having acid-dissociable solubility-reducing groups and a component capable of generating an acid by light.

Nextly, in the second step, the resist film formed in the first step is subjected to a selective light-exposure treatment through a photomask pattern to form a latent image. This light-exposure treatment is conducted by irradiation with active rays.

In the third step, the resist film after formation of a latent image by light irradiation in the aforementioned second step is subjected to a PEB treatment. This treatment is conducted usually by heating for 30 seconds to 150 seconds at a temperature of around 70 to 150 °C.

The fourth step, which is a so-called development step, is a step in which the resist film after the post-exposure baking in the third step is brought into contact with the aforementioned inventive developer composition for lithography so as to obtain explicit exhibition of the latent image.

In the method of the present invention, a molecular layer of a polymer containing a monomeric unit having a nitrogen-containing heterocyclic ring is formed on the surface of the resist film in the course of conducting this fourth step so as to decrease the contact angle in the solid/liquid contact on the resist surface to 40 degrees or lower. As a result, the affinity between the resist film and the developer solution is improved to facilitate contacting of both so that the dissolving velocity of the light-exposed areas into the developer solution is increased along with reduction of the formation of microbubbles due to take-in of the ambient atmospheric air and prevention of re-deposition of the polymer once removed by dissolution leading to a decrease of the defects in the resist pattern obtained. The effect of decreasing the contact angle can be maintained during the stripping treatment subsequently undertaken according to need.

Since semiconductor devices are usually under mass production in which the throughput is an important factor, it is desirable that the time taken for the development treatment be as short as possible and use of an allylamine polymer as the component (B) contained in the developer composition is further advantageous due to the still more shortened treatment time.

That is, when the development treatment is undertaken by using a developer composition for lithography containing a polyallylamine as the component (B), it is sometimes the case that, in conducting the treatment with a rinse solution containing a fluorine-based modifying agent for improvement of the contact angle to pure water on the resist surface to be subsequently undertaken, an advantage is obtained in the improved water draining or, namely, water shake-off. The polyallylamine here should preferably have a molecular weight in the range from 1000 to 60000. When the content of the polyallylamine in this developer composition is increased to some extent, it is possible that the shake-off time, which is about 10 seconds by using other water-soluble or alkali-soluble polymers, is shortened to about one third or around 3 seconds.

While this development treatment is undertaken by supplying or by spraying the developer solution to or at the resist pattern surface or by dipping the resist pattern in the developer solution, it is advantageous to conduct coating such as spin coating because of the dispensability of any new step built in the production line of semiconductor devices if a high throughput is desired.

In the method of the present invention, the resist pattern after the development treatment, on which the contact angle to water has been decreased to 40 degrees or lower, is further optionally subjected, in the fifth step, to a rinse treatment with an aqueous solution or alcoholic solution containing a fluorine-based modifying agent so that the contact angle is increased to 70 degrees or higher to prevent pattern falling.

The fluorine-based modifying agent used here is at least one kind selected from the fluorine compounds having solubility in water or in an alcoholic solvent as represented by the general formula 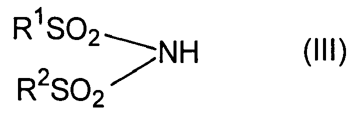 (in the formula, R¹ and R² are each a substituted or unsubstituted alkyl group having 1 to 5 carbon atoms of which a part or all of the hydrogen atoms are substituted by fluorine atoms, R¹ and R² optionally forming a five-membered ring or six-membered ring as bonded each to the other together with a SO₂ group or a nitrogen atom to which the same are bonded,
by the general formula 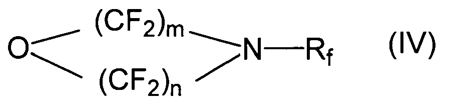 (in the formula, R_{f} is an unsubstituted or substituted alkyl group having 1 to 5 carbon atoms of which a part or all of the hydrogen atoms are substituted by fluorine atoms and m and n are each an integer of 2 or 3),
or by the general formula

R_{f}'COOH (V)

(in the formula, R_{f}' is an alkyl group having 8 to 20 carbon atoms substituted by fluorine atoms for a part or all of the hydrogen atoms).

As the R¹ and R² in the above-given general formula (III), preferable are the substituted or unsubstituted alkyl groups substituted by fluorine atoms for all of the hydrogen atoms including, for example, perfluoroalkyl groups such as perfluoromethyl group, perfluoroethyl group, perfluoropropyl group and perfluorobutyl group. Particularly preferable are those in which R¹ and R² jointly form a five membered ring or six membered ring together with the SO₂ group or nitrogen atom to which they are bonded and all of the hydrogen atoms in R¹ and R² are substituted by fluorine atoms such as, for example, the compounds expressed by

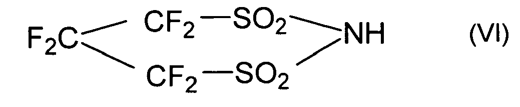

Further, the R_{f} in the general formula (IV) is a substituted or unsubstituted alkyl group having 1 to 5 carbon atoms substituted by fluorine atoms for a part or all of the hydrogen atoms. The substituent group in the substituted alkyl group is exemplified by hydroxyl group, alkoxy groups, carboxyl groups or amino group. Those entirely fluorinated are particularly preferable as the R_{f}.

Such a compound is exemplified, for example, by perfluoro(3-morphorino propionic acid), perfluoro(2-methyl-3-morpholino propionic acid), perfluoro(4-morpholino butyric acid) and the like, of which particularly preferable is perfluoro(2-methyl-3-morpholino propionic acid) expressed by the formula

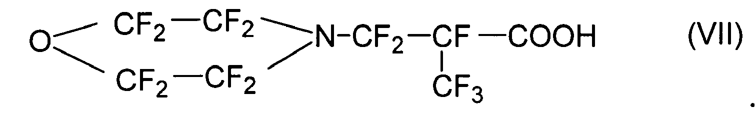

Further, the fluorine compound represented by the general formula (V) is exemplified by decane carboxylic acid, dodecane carboxylic acid, tetradecane carboxylic acid and hexadecane carboxylic acid substituted by fluorine atoms for a part or all of the hydrogen atoms, of which particularly preferable are those substituted by fluorine atoms for all of the hydrogen atoms such as perfluoro(decane carboxylic acid).

These fluorine compounds can be prepared by the fluorination of an unfluorinated starting compound by a known method such as, for example, the electrolytic fluorination method. Besides, lithium salts of those of which the R¹ and R² in the general formula (III) are each a trifluoromethyl group, pentafluoroethyl group or heptafluoropropyl group are marketed under the registered trade name of "Fluorad".

These fluorine compounds are used in the form of a solution as dissolved in water or in a mixture of water and an alcoholic solvent such as methyl alcohol or ethyl alcohol in a concentration of 0.001 to 5.0% by mass or, preferably, 0.01 to 1.0% by mass.

Since fluorine compounds of higher fatty acids are insoluble in water, it is necessary to employ a mixed solvent of an alcoholic solvent such as methyl alcohol or isopropyl alcohol and water or a mixed solvent of water and trifluoroethanol. The mixing proportion of water and an alcohol here should be in the range of 60:40 to 99:1 in the volume ratio.

The fifth step is conducted by subjecting the resist pattern still wet after the development treatment to dipping in a rinse solution containing the fluorine-containing modifying agent or to application of or spraying the rinse solution onto the resist pattern surface. By this treatment, the contact angle on the resist pattern surface to the solution is increased from 40 degrees or lower to 70 degrees or higher or eventually to 90 degrees or higher so that, by conducting a drying treatment by a means such as spin drying and the like maintaining this condition, drying can be accomplished without being accompanied by pattern falling.

It is optional in this treatment according to desire to carry out the treatment with the aforementioned rinse solution at an elevated temperature. Since the surface tension of water, which is 72 dynes/cm at 24 °C, is decreased to 62.6 dynes/cm at 80 °C, pattern falling can further be decreased by increasing the temperature.

In the method of the present invention, it is optional according to desire to further conduct a stripping treatment of the resist pattern obtained in this way so as to completely wash away the unreacted resist. The stripping liquid used here includes, besides pure water, halogenated hydrocarbons such as methylene chloride and tetrachloroethylene, amines and derivatives thereof such as diethanolamine, dimethylformamide, dimethylacetamide and pyrrolidone, hydroxylamine and substituted compounds thereof, glycol ethers such as ethyleneglycol monoethyl ether, 2-butoxyethanol and 2-(butoxyethoxy)ethanol, alkylsulfones such as dimethylsulfone, and others.

Pattern falling is never caused in conducting such a stripping treatment because the contact angle of the resist pattern to the liquid can be maintained high enough.

### BEST MODE FOR CARRYING OUT THE INVENTION

Following is a description of the best mode for practicing the present invention by way of Examples but the present invention is never limited by these Examples.

### Example 1

An antireflection film having a film thickness of 77 nm was formed on a silicon wafer by coating with an antireflection filming agent (produced by Brewer Science, Inc., product name ARC 29A) followed by a heating treatment at 215 °C for 60 seconds. This antireflection film was coated with a chemical-amplification photoresist prepared by dissolving a resinous ingredient expressed by the formula 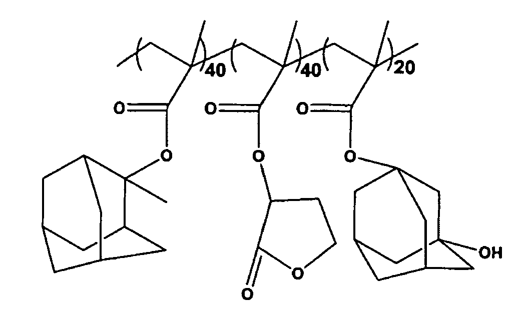 and, relative to the resinous ingredient, 3.0% by mass of triphenylsulfonium perfluorobutane sulfonate and 0.35% by mass of triethanolamine in a mixed solvent of propyleneglycol monomethylether acetate and propyleneglycol monomethyl ether (mixing proportion=6:4) to give an overall solid concentration of 11 % by mass to form a photoresist film of 460 nm film thickness.

Onto the substrate having the thus formed photoresist film, a light-exposure treatment was conducted with a light of 193 nm wavelength by using an ArF excimer stepper (a product by Nikon Corp., product name NSR-S302A) followed by a heating treatment at 130 °C for 90 seconds. The thus obtained photoresist film surface had a contact angle of 76 degrees.

In the next place, development was conducted by coating on a spinner at 2000 rpm for 60 seconds with a developer composition for lithography prepared by adding a vinyl pyrrolidone/vinyl imidazole copolymer (molar ratio 1:1, molecular weight 10000) in a concentration of 0.1 % by mass to a 2.38% by mass aqueous solution of tetramethylammonium hydroxide (solution temperature 23 °C) to obtain a line-and-space (110 nm/150 nm) resist pattern.

After completion of the development treatment, measurements were made for the resist pattern rinse-treated with pure water for 3 seconds at 500 rpm for the contact angle with a contact angle tester (manufactured by Kyowa Interface Science Co., product name "CA-X150") and for the number of defects with a surface defects observation apparatus (manufactured by KLA-Tencor Corp., product name "KLA-2131") to find that the contact angle was 27 degrees and the number of the defects was 15.

For comparison, treatments were undertaken in the same manner excepting the use of a 2.38% aqueous solution of tetramethylammonium hydroxide to find that the contact angle on the thus obtained resist pattern was 76 degrees and the number of defects was at least 10000.

### Example 2

Four different developer compositions for lithography were prepared in just the same way as in Example 1 excepting the use of copolymers of vinyl pyrrolidone (VP) and vinyl imidazole (VI) in a mass ratio of 1:3, 3:1 and 9:1 and a polyvinyl imidazole in place of the vinyl pyrrolidone/vinyl imidazole copolymer of 1:1 molar ratio.

The same procedures as in Example 1 were repeated by using these developer compositions for lithography to obtain the results shown in Table 1.

**Table 1**

| No. | Monomer ratio | | Contact angle (degrees) | Number of defects |
|---|---|---|---|---|
| | VP | VI | | |
| 1 | 1 | 3 | 28 | 10 |
| 2 | 3 | 1 | 30 | 13 |
| 3 | 9 | 1 | 38 | 27 |
| 4 | 0 | 10 | 35 | 21 |

### Example 3

The resist patterns obtained in Example 1 were subjected to a rinse treatment by using 3 kinds of rinse solutions including 0.005% aqueous solutions of perfluoro(2-methyl-3-morpholino propionic acid) (a product by Jemco Inc., product name PFM03, referred to hereinbelow as PFM03), bis(heptafluoropropylsulfonyl)amine (a product by Jemco Inc., product name EF-N331, referred to hereinbelow as EF-N331) and perfluoro(decane carboxylic acid) obtained on the market (referred to hereinbelow as PDC).

This rinse treatment was conducted by dripping the aforementioned rinse solutions for 3 seconds at 500 rotations followed by rinse for 20 seconds with pure water.

The contact angles of the resist pattern surface before and after each rinse solution treatment were determined. The results are shown in Table 2.

Incidentally, a mixed solvent of water and trifluoroethanol (volume proportion 99/1) was used for PDC since this was insoluble in water.

**Table 2**

| No. | Fluorine compound in rinse solution | Contact angle (degrees) | |
|---|---|---|---|
| | | Before treatment | After treatment |
| 1 | PFM03 | 27 | 103 |
| 2 | EF-N331 | 27 | 95 |
| 3 | PDC | 27 | 105 |

Further, the respective substrates after the treatments were examined with an SEM (scanning electron microscope) to find that absolutely no pattern falling and the like could be noted on the substrate surfaces.

### Comparative Example

A rinse treatment was conducted in just the same way as in Example 3 by separately using pure water and isopropyl alcohol as the rinse solutions to find absolutely no increase in the contact angle which remained 27 degrees. Further, a large number of resist pattern fallings were noted by observation of the substrate after the treatments with an SEM (scanning electron microscope).

### INDUSTRIAL UTILIZABILITY

When a resist pattern is formed by using the developer composition of the present invention for lithography, a decrease can be accomplished in the number of defects due to occurrence of microbubbles by entrapping of the air in the step of development and re-deposition of the floating matters in the solution in the steps of development and stripping and, in addition, it is possible even in the use of large-size wafers that the effective ingredients in the developer solution are uniformly dispersed for acting by combindly using at least one kind selected from aliphatic alcohols and alkyl ethers thereof.

Further, pattern falling in the course of rinse can be prevented when combined with the treatment with a rinse solution containing a fluorine-containing modifying agent.

Accordingly, the present invention can be utilized in the manufacture of semiconductor devices such as LSIs, ULSIs and the like by using the lithographic method.

## Claims

1. A developer composition for lithography which is a solution containing (A) a tetraalkylammonium hydroxide, and (B) a water-soluble or alkali-soluble polymer having a constituting monomeric unit having a nitrogen atom in the molecular structure.

2. The developer composition for lithography described in Claim 1 which is a solution containing (A) a tetraalkylammonium hydroxide, (B) a water-soluble or alkali-soluble polymer having a constituting monomeric unit having a nitrogen atom in the molecular structure, and (C) at least one kind selected from aliphatic alcohols and alkyl-etherified compounds thereof.

3. The developer composition for lithography described in Claim 1 wherein the component (A) is tetramethylammonium hydroxide.

4. The developer composition for lithography described in Claim 1 wherein the constituting monomeric unit having a nitrogen atom in the molecular structure in the component (B) is a constituting monomeric unit having a nitrogen-containing heterocyclic group represented by the general formula 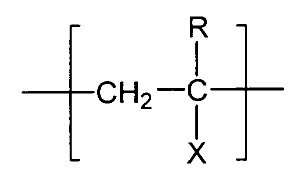 (in the formula, R is a hydrogen atom or a methyl group and X is a nitrogen-containing heterocyclic group).

5. The developer composition for lithography described in Claim 4 wherein the constituting monomeric unit having a nitrogen-containing heterocyclic group is a constituting unit derived from a monomer selected from vinylimidazole, vinylimidazoline, vinylpyridine, vinylpyrrolidone, vinylmorpholine and vinylcaprolactum.

6. The developer composition for lithography described in Claim 1 wherein the water-soluble or alkali-soluble polymer as the component (B) is a copolymer of which the constituting units consist of the constituting units of the monomer having a nitrogen-containing heterocyclic group and the constituting units derived from a monomer capable of forming a water-soluble polymer by polymerization alone.

7. The developer composition for lithography described in Claim 6 wherein the constituting unit derived from a monomer capable of forming a water-soluble polymer by polymerization alone is a constituting unit derived from a monomer selected from among vinyl alcohol and hydroxyalkyl esters of acrylic acid or methacrylic acid.

8. The developer composition for lithography described in Claim 1 wherein the water-soluble or alkali-soluble polymer as the component (B) has a mass-average molecular weight of 500 to 1500000.

9. The developer composition for lithography described in Claim 2 wherein the aliphatic alcohol as the component (C) is at least one kind selected from methanol, ethanol, 1-propanol, 2-propanol, n-butyl alcohol, isobutyl alcohol, *tert*-butyl alcohol and the compounds substituted by fluorine atoms for a part or all of the hydrogen atoms thereof.

10. The developer composition for lithography described in Claim 2 wherein the alkyl-etherified compound of an aliphatic alcohol as the component (C) is at least one kind selected from alkyleneglycols or alkyl ethers thereof, polyalkyleneglycols or alkyl ethers thereof and glycerin.

11. The developer composition for lithography described in Claim 10 wherein the alkyleneglycol or an alkyl ether thereof is at least one kind selected from 1,2-ethyleneglycol, 1,3-propanediol, 1,4-butanediol, 2,3-butanediol and 1,5-pentanediol and methyl, ethyl or propyl ethers thereof.

12. The developer composition for lithography described in Claim 10 where-in the polyalkyleneglycol or an alkyl ether thereof is at least one kind selected from diethyleneglycol, triethyleneglycol, tetraethyleneglycol, dipropyleneglycol, tripropyleneglycol, polyethyleneglycol, polypropyreneglycol and poly(oxyethyl-ene/oxypropylene) glycol and methyl, ethyl or propyl ethers thereof.

13. The developer composition for lithography described in Claim 1 wherein the concentration of the component (A) is in the range of 0.5 to 10.0% by mass and the concentration of the component (B) is in the range of 0.001 to 10% by mass.

14. The developer composition for lithography described in Claim 2 wherein the concentration of the component (C) is in the range of 0.0001 to 15% by mass.

15. A method for the formation of a resist pattern which comprises:
(1) a step for providing a resist film on a substrate;
(2) a step for subjecting the said resist film to a selective light-exposure treatment through a photomask pattern;
(3) a step for subjecting the said resist film after the light-exposure treatment to a post exposure baking (PEB) treatment; and
(4) a step for subjecting the said resist film after the PEB treatment to a development treatment with the developer composition for lithography described in Claim 1.

16. A method for the formation of a resist pattern which comprises:
(1) a step for providing a resist film on a substrate;
(2) a step for subjecting the said resist film to a selective light-exposure treatment through a photomask pattern;
(3) a step for subjecting the said resist film after the light-exposure treatment to a post exposure baking (PEB) treatment;
(4) a step for subjecting the said resist film after the PEB treatment to a development treatment with the developer composition for lithography described in Claim 1; and
(5) a step for subjecting the said resist film after the development treatment to a rinse treatment with an aqueous solution or an alcoholic solution containing a fluorine-containing modifying agent.

17. The method for the formation of a resist pattern described in Claim 16 wherein the fluorine-containing modifying agent is at least one kind selected from the fluorine compounds soluble in water or in an alcoholic solvent represented by the general formula 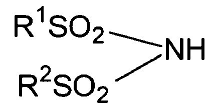 (R¹ and R² in the formula are each a substituted or unsubstituted alkyl group having 1 to 5 carbon atoms of which a part or all of the hydrogen atoms are replaced by fluorine atoms with an optional proviso that R¹ and R² jointly form a five-membered ring or six-membered ring together with the SO₂ group and the nitrogen atom to which both are bonded),
by the general formula 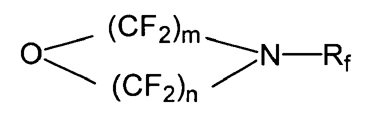 (R_{f} in the formula is a substituted or unsubstituted alkyl group having 1 to 5 carbon atoms substituted by fluorine atoms for a part or all of the hydrogen atoms and m and n are each an integer of 2 or 3)
and by the general formula
R_{f}'-COOH
(R_{f}' in the formula is an alkyl group having 8 to 20 carbon atoms substituted by fluorine atoms for a part or all of the hydrogen atoms).

18. The method for the formation of a resist pattern described in Claim 17 wherein the fluorine-containing modifying agent is a compound expressed by the formula

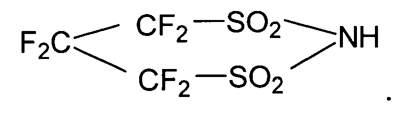

19. The method for the formation of a resist pattern described in Claim 17 wherein the fluorine-containing modifying agent is a compound expressed by the formula
